# EUROPEAN PATENT APPLICATION

(11) **EP 4 350 762 A1**
(43) Date of publication of application: **10.04.2024**
(21) Application number: 23199096.1
(22) Date of filing: 22.09.2023
(51) Int. Cl.: H01L 23/48, H01L 23/528, H01L 27/02, H10B 10/00

(54) **INTEGRATED CIRCUIT INCLUDING BACKSIDE WIRING AND METHOD OF DESIGNING THE SAME**

(30) Priority: 06.10.2022 KR 20220128055; 11.01.2023 KR 20230004291
(71) Applicant: Samsung Electronics Co., Ltd., Suwon-si, Gyeonggi-do 16677 (KR)
(72) Inventor: KIM, Taehyung, Suwon-si, Gyeonggi-do 16677 (KR); TANG, Hoyoung, Suwon-si, Gyeonggi-do 16677 (KR); PARK, Yunsick, Suwon-si, Gyeonggi-do 16677 (KR)
(74) Representative: Kuhnen & Wacker Patent- und Rechtsanwaltsbüro PartG mbB

(57) **Abstract**

Provided is an integrated circuit including a cell region in which a plurality of cells are arranged, and a peripheral region in which a circuit configured to control the plurality of cells is arranged, wherein the cell region further includes a plurality of first gate lines over a substrate, a plurality of first patterns in a first wiring layer above the plurality of first gate lines, a plurality of second patterns extending in a first horizontal direction in a backside wiring layer under the substrate, and a plurality of first vias, each of the plurality of first vias passing through the substrate in a vertical direction, wherein each of the plurality of first vias includes a top surface connected to a respective one of the plurality of first patterns and a bottom surface connected to a respective one of the plurality of second patterns.

## Description

### CROSS-REFERENCE TO RELATED APPLICATIONS

This application claims priority to Korean Patent Application No. 10-2022-0128055, filed on October 6, 2022, and Korean Patent Application No. 10-2023-0004291, filed on January 11, 2023, in the Korean Intellectual Property Office, the disclosures of which are incorporated by reference herein in their entireties.

### BACKGROUND

Embodiments of the present disclosure relate to an integrated circuit, and more particularly, to an integrated circuit including a backside wiring and a method of designing the same.

Due to the demand on a high degree of integration and development of semiconductor processes, widths, spaces, and/or heights of wiring lines included in an integrated circuit may be decreased, and the influence of parasitic elements of the wiring lines may increase. In addition, a power supply voltage of the integrated circuit may be reduced for reduced power consumption and a high operation speed, and thus the influence of the parasitic elements of the wiring lines on the integrated circuit may increase. In spite of such parasitic elements, an integrated circuit including a cell array including cells having the same structure may be required to more stably provide a high degree of integration and performance according to the requirements of various applications.

### SUMMARY

One or more embodiments provide an integrated circuit including a cell array routed by a backside wiring and a method of designing the same.

According to an aspect of an embodiment, there is provided an integrated circuit including a cell region in which a plurality of cells are arranged, and a peripheral region in which a circuit configured to control the plurality of cells is arranged, wherein the cell region further includes a plurality of first gate lines over a substrate, a plurality of first patterns in a first wiring layer above the plurality of first gate lines, a plurality of second patterns extending in a first horizontal direction in a backside wiring layer under the substrate, and a plurality of first vias, each of the plurality of first vias passing through the substrate in a vertical direction, wherein each of the plurality of first vias includes a top surface connected to a respective one of the plurality of first patterns and a bottom surface connected to a respective one of the plurality of second patterns.

According to another aspect of an embodiment, there is provided an integrated circuit including a cell region in which a plurality of cells are arranged, and a peripheral region in which a circuit configured to control the plurality of cells is arranged, wherein the cell region includes a plurality of first gate lines over a substrate, a plurality of first patterns extending in a first wiring layer above the plurality of first gate lines, and a plurality of second patterns extending in a first horizontal direction in a backside wiring layer under the substrate, wherein each of the plurality of second patterns is configured to receive a control signal provided commonly to cells, among the plurality of cells, in a row extending in the first horizontal direction.

According to another aspect of an embodiment, there is provided an integrated circuit including a cell region in which a plurality of cells are arranged, and a peripheral region adjacent to the cell region and in which a circuit configured to control the plurality of cells is arranged, wherein the cell region includes a plurality of first gate lines over a substrate, a plurality of first patterns extending in a first wiring layer above the plurality of first gate lines, a plurality of second patterns extending in a first horizontal direction in a backside wiring layer under the substrate, the plurality of second patterns being configured to receive a first supply voltage supplied to the plurality of cells, and a plurality of first vias, each of the plurality of first vias passing through the substrate in a vertical direction and connected to a respective one of the plurality of first patterns and a respective one of the plurality of second patterns..

### BRIEF DESCRIPTION OF THE DRAWINGS

Embodiments will be more clearly understood from the following detailed description taken in conjunction with the accompanying drawings in which:
FIG. 1 is a diagram showing a layout of an integrated circuit according to an embodiment;
FIGS. 2A, 2B, 2C, and 2D are diagrams showing examples of an element according to embodiments;
FIG. 3 is a block diagram showing an integrated circuit according to an embodiment;
FIG. 4 is a plan view showing a layout of an integrated circuit according to an embodiment;
FIG. 5 is a circuit diagram showing a memory cell according to an embodiment;
FIGS. 6A and 6B are plan views showing a layout of an integrated circuit according to embodiments;
FIGS. 7A, 7B, 7C, 7D, and 7E are plan views showing layouts of an integrated circuit according to embodiments;
FIGS. 8A, 8B, 8C, 8D, and 8E are plan views showing layouts of an integrated circuit according to embodiments;
FIGS. 9A and 9B are plan views showing layouts of an integrated circuit according to embodiments;
FIG. 10 is a flowchart showing a method of manufacturing an integrated circuit, according to an embodiment;
FIG. 11 is a flowchart showing a method of designing an integrated circuit, according to an embodiment;
FIG. 12 is a block diagram showing a system-on-chip according to an embodiment; and
FIG. 13 is a block diagram showing a computing system including a memory storing a program, according to an embodiment.

### DETAILED DESCRIPTION

Embodiments described herein are example embodiments, and thus, the disclosure is not limited thereto.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

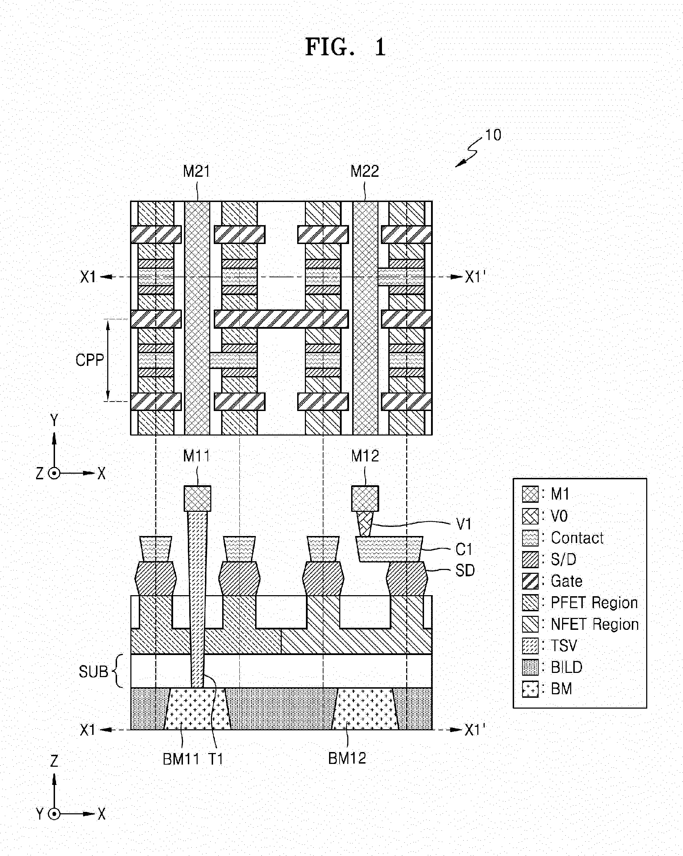

FIG. 1 is a diagram showing a layout of an integrated circuit 10 according to an embodiment. For example, the upper image of FIG. 1 is a plan view showing the layout of the integrated circuit 10 in a -Z-axis direction, and the lower image of FIG. 1 is a cross-sectional view showing a cross-section of the layout of the integrated circuit 10 taken along line X1-X1'.

Herein, an X-axis direction and a Y-axis direction may each be referred to as a horizontal direction, and a Z-axis direction may be referred to as a vertical direction. A plane formed by an X axis and a Y axis may be referred to as a horizontal plane, a component relatively arranged in a +Z direction than another component may be considered to be above the another component, and a component relatively arranged in a -Z direction than another component may be considered to be under the another component. In addition, the area of a component may refer to a size occupied by the component on a plane parallel to the horizontal plane, and the width of a component may refer to a length in a direction perpendicular to a direction in which the component extends. A surface exposed in the +Z direction may be referred to as a top surface, a surface exposed in the -Z direction may be referred to as a bottom surface, and a surface exposed in a ±X direction or ±Y direction may be referred to as a side surface. For convenience of illustration, only some layers may be shown in the drawings, and for understanding, although a via connecting an upper pattern and a lower pattern together is located under the upper pattern, the via may be illustrated in the upper pattern. In addition, a pattern including a conductive material, such as a pattern of a wiring layer, may be referred to as a conductive pattern or may simply be referred to as a pattern.

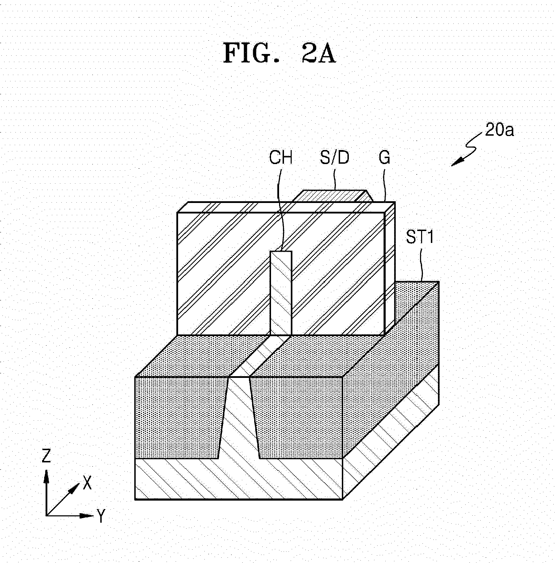

Referring to FIG. 1, the integrated circuit 10 may include gate lines (or gate electrodes) extending in the X-axis direction, and may include p-channel field effect transistor (PFET) regions and n-channel field effect transistor (NFET) regions extending in the Y-axis direction. A pitch of gate lines may be referred to as a contact-poly-pitch (CPP). As described below with reference to FIGS. 2A to 2C, portions protruding in a +Z-axis direction and extending in the Y-axis direction in each of a PFET region and an NFET region may form a transistor together with a gate line, and may be referred to as an active pattern. A source/drain may be formed at both sides of a gate line, a contact may be formed on the source/drain, and a channel may be formed under the gate line and between the source/drains. Examples of the channel are described below with reference to FIGS. 2A to 2D. A via of a first via layer V0 may be arranged on a contact, and the via may be connected to the contact and a pattern of a first wiring layer M1. For example, as shown in FIG. 1, a via V1 may be connected to a contact C1 and a pattern M12. A source/drain SD may be connected to the contact C1. At least one additional wiring layer may be present above the first wiring layer M1, and patterns may extend in the at least one additional wiring layer.

The integrated circuit 10 may include patterns extending in the Y-axis direction in a backside wiring layer under a substrate SUB. For example, as shown in FIG. 1, in a backside metal layer BM, a first pattern BM11 may extend under the PFET region in the Y-axis direction. In addition, in the backside metal layer BM, a second pattern BM12 may extend under the NFET region in the Y-axis direction. A backside interlayer dielectric (BILD) may be formed between the first pattern BM11 and the second pattern BM12.

The integrated circuit 10 may include a through silicon via passing through the substrate SUB in the vertical direction. The through silicon via may connect a pattern of the first wiring layer M1 to a pattern of the backside wiring layer. For example, as shown in FIG. 1, a through silicon via T1 may pass through the substrate SUB, and may have a bottom surface connected to the first pattern BM11 of the backside wiring layer and a top surface connected to a pattern M11 of the first wiring layer M1. Similarly, the integrated circuit 10 may include a through silicon via having a bottom surface connected to the second pattern BM12 of the backside wiring layer and a top surface connected to the pattern M12 of the first wiring layer M1.

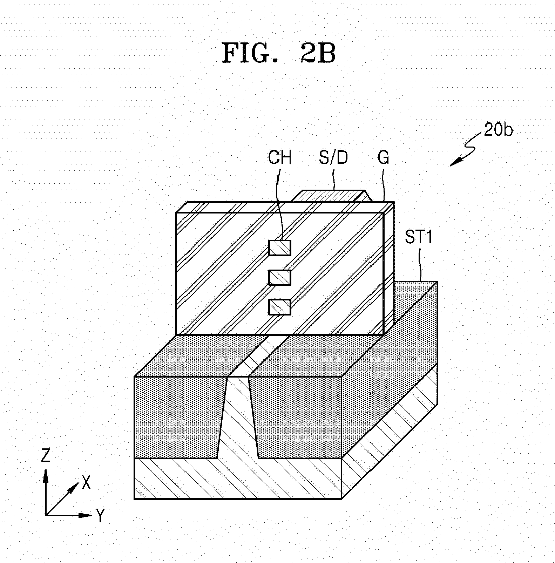

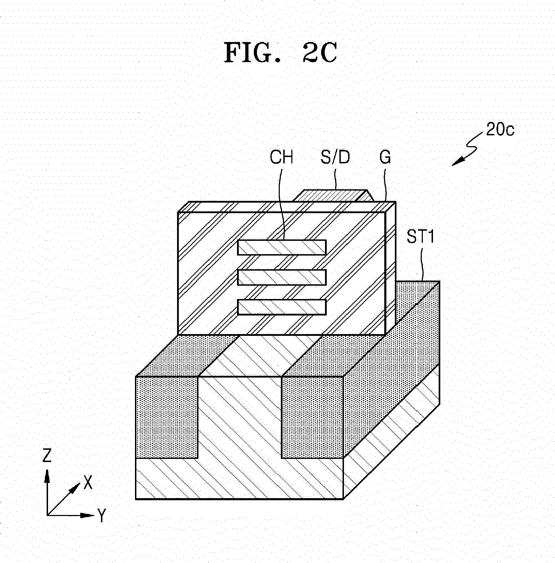

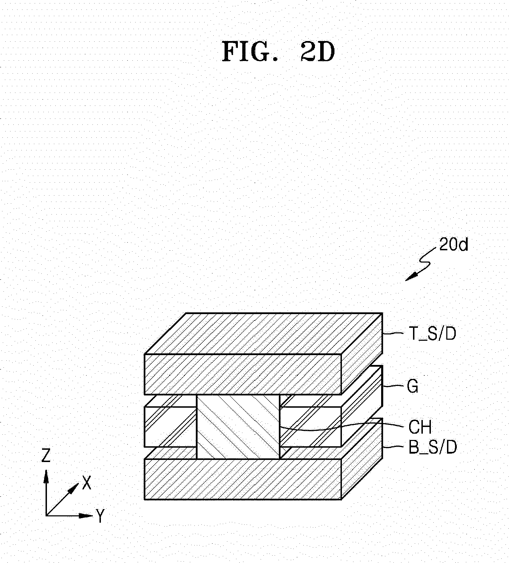

FIGS. 2A to 2D are diagrams showing examples of an element according to embodiments. For example, FIG. 2A shows a FinFET 20a, FIG. 2B shows a gate-all-around field effect transistor (GAAFET) 20b, FIG. 2C shows a multi-bridge channel field effect transistor (MBCFET) 20c, and FIG. 2D shows a vertical field effect transistor (VFET) 20d. For convenience of illustration, FIGS. 2A to 2C illustrate a state in which one of two source/drain regions is removed, and FIG. 2D shows a cross-section of the VFET 20d cut with a plane parallel to a plane formed by a Y axis and a Z axis and passing through a channel CH of the VFET 20d.

Referring to FIG. 2A, the FinFET 20a may be formed by a fin-shaped active pattern extending between shallow trench isolations (STIs) in the X-axis direction and a gate G extending in the Y-axis direction. A source/drain S/D may be formed at both sides of the gate G, and accordingly, the source and the drain may be spaced apart from each other in the X-axis direction. An insulating film may be formed between the channel CH and the gate G. In some embodiments, the FinFET 20a may be formed by a plurality of active patterns spaced apart from each other in the Y-axis direction and the gate G.

Referring to FIG. 2B, the GAAFET 20b may be formed by active patterns, that is, nanowires, spaced apart from each other in the Z-axis direction and extending in the X-axis direction, and the gate G extending in the Y-axis direction. The source/drain S/D may be formed at both sides of the gate G, and accordingly, the source and the drain may be spaced apart from each other in the X-axis direction. An insulating film may be formed between the channel CH and the gate G. The number of nanowires included in the GAAFET 20b is not limited to those shown in FIG. 2B.

Referring to FIG. 2C, the MBCFET 20c may be formed by active patterns, that is, nanosheets, spaced apart from each other in the Z-axis direction and extending in the X-axis direction, and the gate G extending in the Y-axis direction. The source/drain S/D may be formed at both sides of the gate G, and accordingly, the source and the drain may be spaced apart from each other in the Y-axis direction. An insulating film may be formed between the channel CH and the gate G. The number of nanosheets included in the MBCFET 20c is not limited to those shown in FIG. 2C.

Referring to FIG. 2D, the VFET 20d may include a top source/drain T_SID and a bottom source/drain B_S/D, spaced apart from each other in the Z-axis direction, with the channel CH therebetween. The VFET 20d may include the gate G surrounding the perimeter of the channel CH, the gate G being between the top source/drain T_SID and the bottom source/drain B_S/D. An insulating film may be formed between the channel CH and the gate G.

Hereinafter, an integrated circuit including the FinFET 20a or the MBCFET 20c is mainly described, but elements included in the integrated circuit are not limited to examples of FIGS. 2A to 2D. For example, the integrated circuit may include a ForkFET having a structure in which nanosheets for a P-type transistor and nanosheets for an N-type transistor are separated by a dielectric wall to bring the N-type transistor and the P-type transistor closer together. In addition, the integrated circuit may also include a bipolar junction transistor as well as a FET, such as a complementary field effect transistor (CFET), a negative capacitance field effect transistor (NCFET), or a carbon nanotube (CNT) FET.

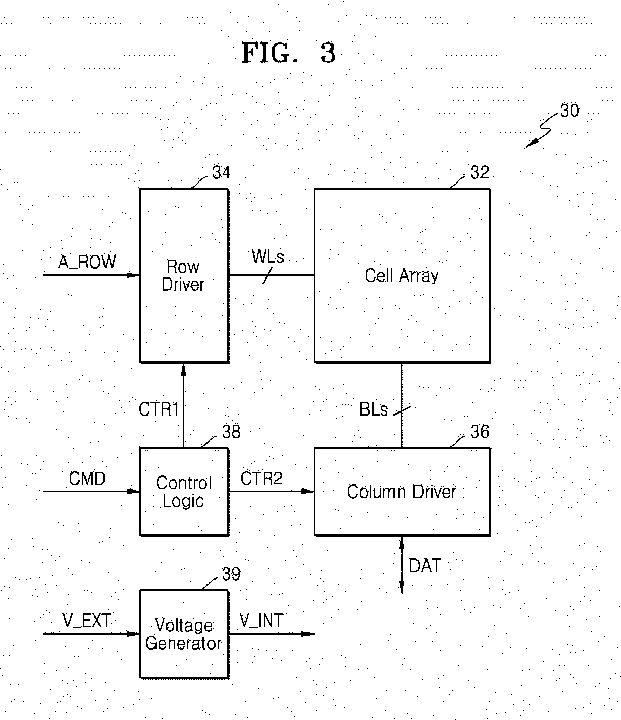

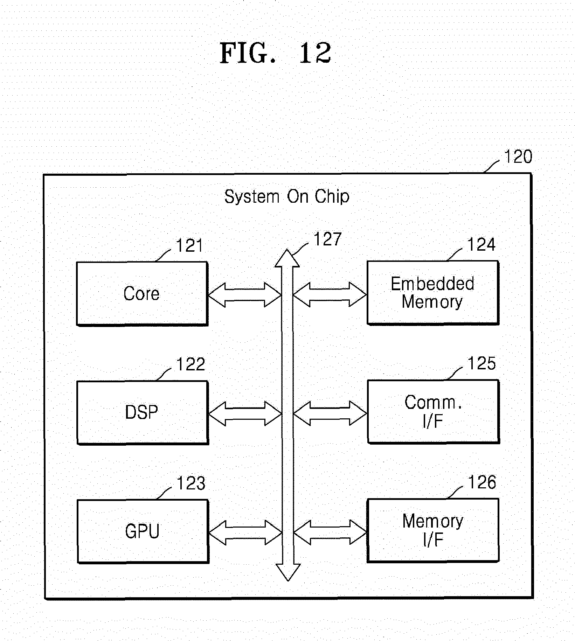

FIG. 3 is a block diagram showing an integrated circuit according to an embodiment. For example, the block diagram of FIG. 3 shows a memory device 30 included in the integrated circuit. In some embodiments, the memory device 30 may store data based on a command and an address, provided from the outside of the integrated circuit, and the memory device 30 may be a standalone memory device or may include one or more memory devices. In addition, in some embodiments, as described below with reference to FIG. 12, the integrated circuit may include other components for writing data to the memory device 30 or reading data from the memory device 30, and the memory device 30 may be an embedded memory device. As shown in FIG. 3, the memory device 30 may include a cell array 32, a row driver 34, a column driver 36, a control logic 38, and a voltage generator 39. Components other than the cell array 32 in the memory device 30, that is, the row driver 34, the column driver 36, the control logic 38, and the voltage generator 39, may be collectively referred to as peripheral circuits. In some embodiments, the memory device 30 may include an address buffer, a data buffer, and a data input/output circuit.

The memory device 30 may receive a command CMD, an address, and data DAT. For example, the memory device 30 may receive the command CMD instructing to write data, an address, and the data DAT, and may store the received data DAT in a region of the cell array 32 corresponding to the address. In addition, the memory device 30 may receive the command CMD instructing to read data and an address, and may output, to the outside, data stored in a region of the cell array 32 corresponding to the address.

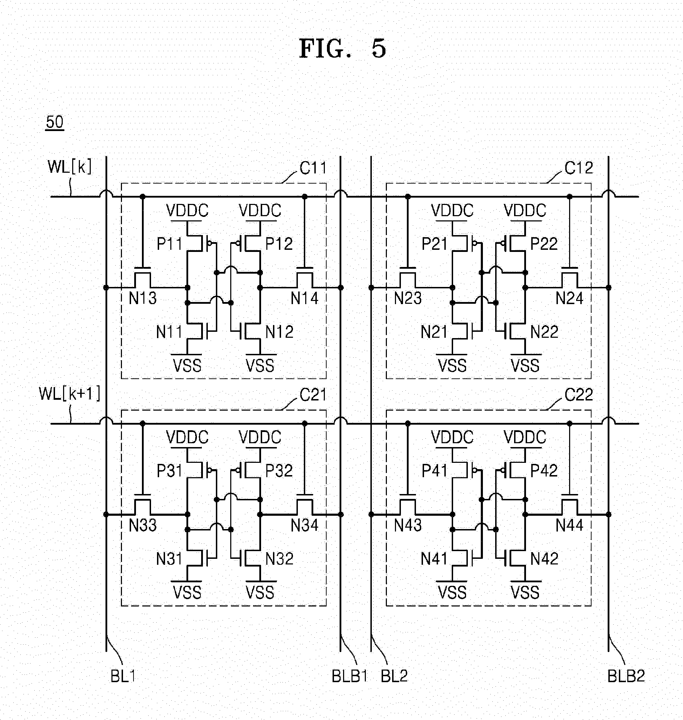

The cell array 32 may include a plurality of memory cells, each accessed by a word line and a bit line. In some embodiments, the memory cells included in the cell array 32 may be memory cells included in a volatile memory, such as static random access memory (SRAM) and dynamic random access memory (DRAM). In some embodiments, the memory cells included in the cell array 32 may be memory cells included in a non-volatile memory, such as flash memory and resistive random access memory (RRAM). Embodiments are described mainly with reference to an SRAM cell as described below with reference to FIG. 5 or the like, but embodiments are not limited thereto. Herein, a memory cell may simply be referred to as a cell.

The row driver 34 may be connected to the cell array 32 via a plurality of word lines WLs. The row driver 34 may activate one word line among the plurality of word lines WLs based on a row address A_ROW. Accordingly, memory cells connected to the activated word line, that is, memory cells arranged in a row corresponding to the activated word line, may be selected from among the memory cells included in the cell array 32. By the column driver 36, the data DAT may be written to the selected memory cells during a write operation, and the data DAT may be read from the selected memory cells during a read operation.

The column driver 36 may be connected to the cell array 32 via a plurality of bit lines BLs. By sensing a current and/or a voltage received via the plurality of bit lines BLs during the read operation, the column driver 36 may identify values stored in the memory cells connected to the activated word line, that is, the selected memory cells, and may output the data DAT based on the identified values. In addition, the column driver 36 may apply a current and/or a voltage to the plurality of bit lines BLs based on the data DAT during the write operation, and may write values to the memory cells connected to the activated word line, that is, the selected memory cells.

The control logic 38 may receive the command CMD and may generate a first control signal CTR1 and a second control signal CTR2. For example, the control logic 38 may identify a read command by decoding the command CMD, and may generate the first control signal CTR1 and the second control signal CTR2 to read the data DAT from the cell array 32. In addition, the control logic 38 may identify a write command by decoding the command CMD, and may generate the first control signal CTR1 and the second control signal CTR2 to write the data DAT to the cell array 32. In some embodiments, the row driver 34 may activate or deactivate a word line at a timing determined based on the first control signal CTR1. In addition, in some embodiments, at a timing determined based on the second control signal CTR2, the column driver 36 may sense a current and/or a voltage from the plurality of bit lines BLs, or may apply a current and/or a voltage to the plurality of bit lines BLs.

The voltage generator 39 may receive an external voltage V_EXT provided from the outside of the memory device 30, and may provide an internal voltage V_INT to other components of the memory device 30, that is, the cell array 32, the row driver 34, the column driver 36, and the control logic 38. For example, the voltage generator 39 may receive an external cell voltage VDDCE as the external voltage V_EXT, and may generate a cell voltage VDDC from the external cell voltage VDDCE. The cell voltage VDDC as the internal voltage V_INT may be provided to the cell array 32, and may provide power to the plurality of memory cells included in the cell array 32. In addition, the voltage generator 39 may receive an external peripheral voltage VDDPE as the external voltage V_EXT, and may generate a peripheral voltage VDDP from the external peripheral voltage VDDPE. The peripheral voltage VDDP as the internal voltage V_INT may be provided to a peripheral circuit, for example, the row driver 34, the column driver 36, and the control logic 38, and may provide power to the row driver 34, the column driver 36, and the control logic 38. The external cell voltage VDDCE, the cell voltage VDDC, the external peripheral voltage VDDPE, and the peripheral voltage VDDP may be referred to as positive supply voltages as voltages for power supply, and a negative supply voltage VSS may be used for power supply.

In some embodiments, the memory device 30 may include patterns extending in a backside wiring layer under a substrate. For example, as described above with reference to FIG. 1, the gate electrodes may extend over the substrate SUB, and patterns of the first wiring layer M1 may extend above the gate electrodes. In addition, patterns may extend in the backside wiring layer under the gate electrodes or under the substrate SUB. The patterns extending in the backside wiring layer may be used to route a supply voltage or a signal. Accordingly, routing resources may increase in the memory device 30, and the area of the memory device 30 may decrease. In addition, parasitic components of a wiring line may decrease, and performance of the memory device 30 may increase.

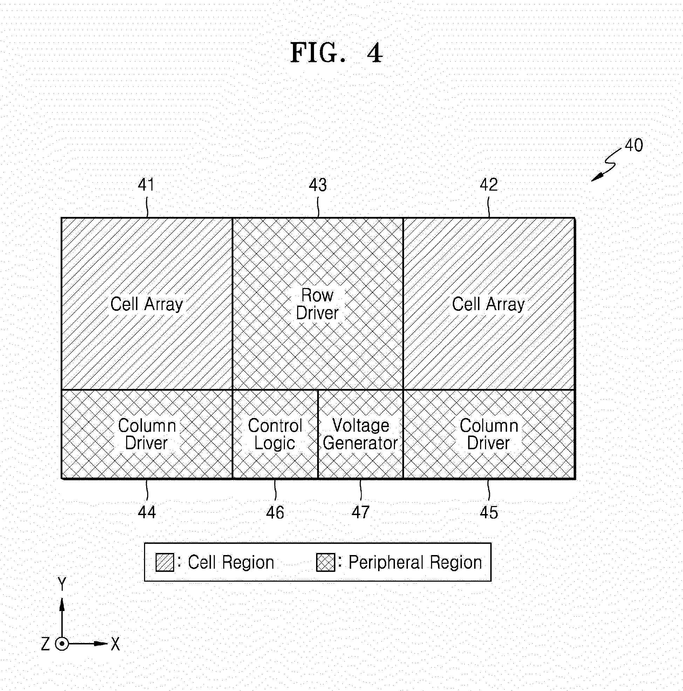

FIG. 4 is a plan view showing a layout of an integrated circuit according to an embodiment. For example, the plan view of FIG. 4 shows a layout 40 corresponding to the memory device 30 of FIG. 3. Hereinafter, FIG. 4 is described with reference to FIG. 3.

The layout 40 may include at least one cell array in a cell region, and may include a peripheral circuit in a peripheral region. For example, as shown in FIG. 4, the cell region may include a first cell array 41 and a second cell array 42, and the peripheral region may include a row driver 43, a first column driver 44, a second column driver 45, a control logic 46, and a voltage generator 47. In some embodiments, the row driver 43, the first column driver 44, the second column driver 45, the control logic 46, and the voltage generator 47 may be arranged differently from those in the peripheral region shown in FIG. 4.

Patterns corresponding to the plurality of word lines WLs may extend parallel to each other in the X-axis direction in the first cell array 41 and the second cell array 42, and may be connected to the row driver 43. Patterns corresponding to the plurality of bit lines BLs may extend parallel to each other in the first cell array 41 and the second cell array 42 in the Y-axis direction, and may be connected to the first column driver 44 and the second column driver 45. As described above with reference to FIG. 3, patterns of a backside wiring layer under a substrate may extend in the cell region and the peripheral region.

FIG. 5 is a circuit diagram showing a memory cell according to an embodiment. For example, the circuit diagram of FIG. 5 shows an equivalent circuit 50 corresponding to four memory cells C11, C12, C21, and C22 arranged adjacent to each other in the cell array 32 of FIG. 3. As shown in FIG. 5, the memory cells C 11, C12, C21, and C22 may have the same structure.

Referring to FIG. 5, the memory cell C11 and the memory cell C12 arranged in the same row may be commonly connected to a word line WL[k], and the memory cell C21 and the memory cell C22 arranged in the same row may be commonly connected to a word line WL[k+1], where k is an integer greater than 0. In addition, the memory cell C11 and the memory cell C21 arranged in the same column may be connected to a first bit line BL1 and a first complementary bit line BLB 1, and the memory cell C12 and the memory cell C22 arranged in the same column may be connected to a second bit line BL2 and a second complementary bit line BLB2.

Referring to FIG. 5, the memory cell C11 may include a first PFET P11, a second PFET P12, and a first NFET N11, a second NFET N12, a third NFET N13, and a fourth NFET N14, and may be a six transistors (6T) SRAM cell. The memory cell C11 may include a cross-coupled inverter pair between a node to which the cell voltage VDDC is applied and a node to which the negative supply voltage (or ground potential) VSS is applied. For example, a first inverter of the cross-coupled inverter pair may include the first PFET P11 and the first NFET N11, and a second inverter of the cross-coupled inverter pair may include the second PFET P12 and the second NFET N12. In addition, the third NFET N13 and the fourth NFET N14 may be referred to as pass transistors configured to connect the first inverter and the second inverter to the first bit line BL1 and the first complementary bit line BLB1, respectively, by the word line WL[k] that is activated, for example, that has a relatively high-level voltage.

The memory cell C12 may include a first PFET P21, a second PFET P22, and first NFET N21, a second NFET N22, a third NFET N23, and a fourth NFET N24, and may be a 6T SRAM cell. The memory cell C12 may include a cross-coupled inverter pair between a node to which the cell voltage VDDC is applied and a node to which the negative supply voltage (or ground potential) VSS is applied. For example, a first inverter of the cross-coupled inverter pair may include the first PFET P21 and the first NFET N21, and a second inverter of the cross-coupled inverter pair may include the second PFET P22 and the second NFET N22. In addition, the third NFET N23 and the fourth NFET N24 may be referred to as pass transistors configured to connect the first inverter and the second inverter to the second bit line BL2 and the second complementary bit line BLB2, respectively, by the word line WL[k] that is activated, for example, that has a relatively high-level voltage.

The memory cell C21 may include a first PFET P31, a second PFET P32, and first NFET N31, a second NFET N32, a third NFET N33, and a fourth NFET N34, and may be a 6T SRAM cell. The memory cell C21 may include a cross-coupled inverter pair between a node to which the cell voltage VDDC is applied and a node to which the negative supply voltage (or ground potential) VSS is applied. For example, a first inverter of the cross-coupled inverter pair may include the first PFET P31 and the first NFET N31, and a second inverter of the cross-coupled inverter pair may include the second PFET P32 and the second NFET N32. In addition, the third NFET N33 and the fourth NFET N34 may be referred to as pass transistors configured to connect the first inverter and the second inverter to the first bit line BL1 and the first complementary bit line BLB1, respectively, by the word line WL[k+1] that is activated, for example, that has a relatively high-level voltage.

The memory cell C22 may include a first PFET P41, a second PFET P42, and first NFET N41, a second NFET N42, a third NFET N43, and aa fourth NFET N44, and may be a 6T SRAM cell. The memory cell C22 may include a cross-coupled inverter pair between a node to which the cell voltage VDDC is applied and a node to which the negative supply voltage (or ground potential) VSS is applied. For example, a first inverter of the cross-coupled inverter pair may include the first PFET P41 and the first NFET N41, and a second inverter of the cross-coupled inverter pair may include the second PFET P42 and the second NFET N42. In addition, the third NFET N43 and the fourth NFET N44 may be referred to as pass transistors configured to connect the first inverter and the second inverter to the second bit line BL2 and the second complementary bit line BLB2, respectively, by the word line WL[k+1] that is activated, for example, that has a relatively high-level voltage.

When a voltage drop occurs at the node to which the cell voltage VDDC is applied or the node to which the negative supply voltage VSS is applied, the memory cell C11 may not appropriately output a signal corresponding to a value latched to the cross-coupled inverter pair to the first bit line BL1 and the first complementary bit line BLB1, and may not appropriately latch a value corresponding to a signal applied to the first bit line BL1 and the first complementary bit line BLB1 to the cross-coupled inverter pair. In addition, as the number of memory cells included in one row increases, the word line WL[k] may extend, and the influence of parasitic resistance of the word line WL[k] may increase. Accordingly, a memory cell remote from the row driver 34 of FIG. 3 may identify activation of a word line at a delayed time point, and the operating speed of the memory device 30 of FIG. 3 may be limited.

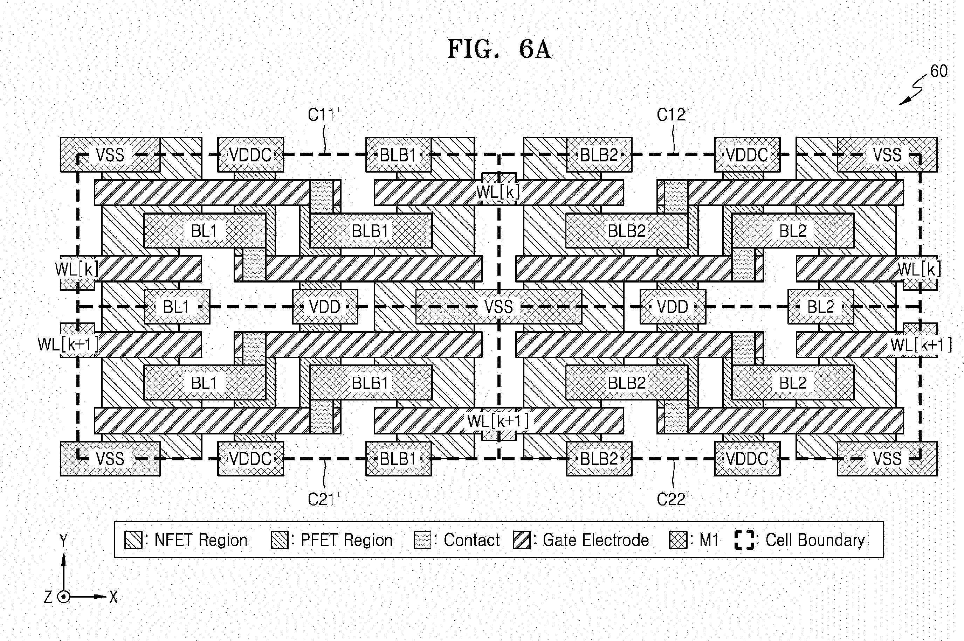

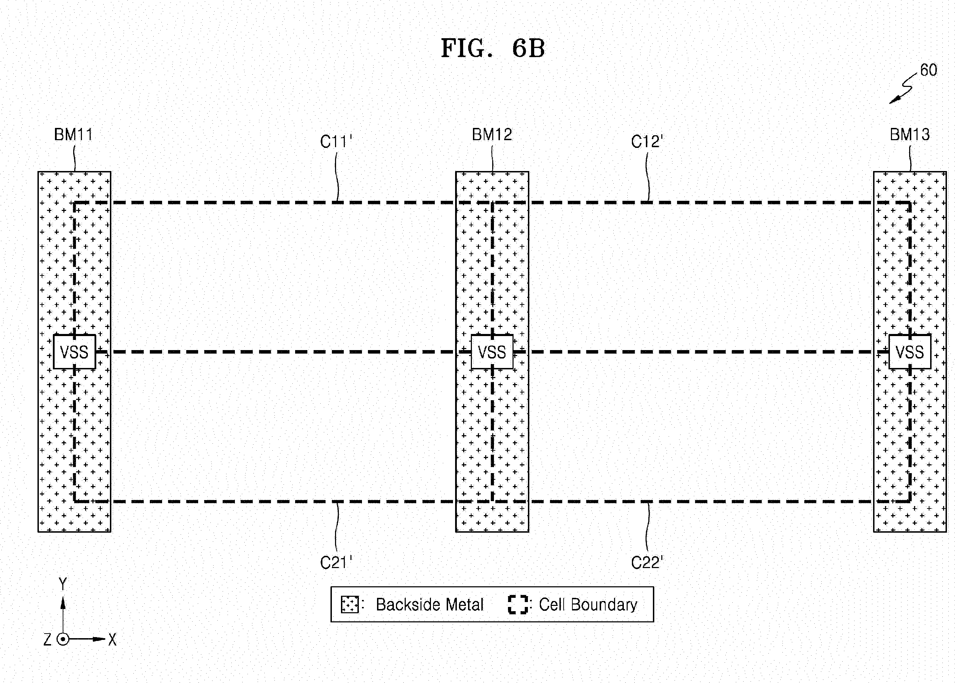

FIGS. 6A and 6B are plan views showing a layout 60 of an integrated circuit according to embodiments. For example, the plan views of FIGS. 6A and 6B show the layout 60 including memory cells C11', C12', C21', and C22' corresponding to the four memory cells C11, C12, C21, and C22, respectively, included in the equivalent circuit 50 of FIG. 5. The plan view of FIG. 6A shows some layers over a substrate in the layout 60, and the plan view of FIG. 6B shows a backside wiring layer under the substrate in the layout 60. In FIGS. 6A and 6B, a name written on a pattern indicates a line to which the corresponding pattern is electrically connected and/or a voltage applied to the pattern. For convenience of illustration, the illustration of a source/drain is omitted in FIG. 6A. The equivalent circuit 50 of FIG. 5 is not limited to the layout 60 of FIGS. 6A and 6B.

Referring to FIG. 6A, the four memory cells C11', C12', C21', and C22' may have the same size. The size may refer to a space occupied by a component on a plane. For example, the four memory cells C1 1', C12', C21', and C22' may have the same area, and may have the same horizontal length (or the same length in the X-axis direction) and the same vertical length (or the same length in the Y-axis direction). The memory cell C11' and the memory cell C12' arranged in the same row may be commonly connected to the word line WL[k]. The memory cell C21' and the memory cell C22' arranged in the same row may be commonly connected to the word line WL[k+1]. The memory cell C11' and the memory cell C21' arranged in the same column may be commonly connected to the first bit line BL1 and the first complementary bit line BLB1. The memory cell C12' and the memory cell C22' arranged in the same column may be commonly connected to the second bit line BL2 and the second complementary bit line BLB2.

The memory cell C11' may include an NFET region and a PFET region, extending in the Y-axis direction. For example, as shown in FIG. 6A, NFET regions may extend, in the Y-axis direction, between PFET regions of the memory cell C11', extending in the Y-axis direction. The memory cell C11' may include a gate electrode extending in the X-axis direction. The gate electrode may form NFETs, that is, the first to fourth NFETs N11 to N14 of FIG. 5, in the NFET region, and may form PFETs, that is, the first PFET P11 and the second PFET P12 of FIG. 5, in the PFET region. Source/drains may be formed at both sides of the gate electrode, and a source/drain may be connected to a pattern of an M1 layer via a contact (referred to as a source/drain contact) and a via. The gate electrode may be connected to the pattern of the M1 layer via a contact (referred to as a gate contact) and a via.

The memory cell C12' may include an NFET region and a PFET region, extending in the Y-axis direction. For example, as shown in FIG. 6A, NFET regions may extend, in the Y-axis direction, between PFET regions of the memory cell C12', extending in the Y-axis direction. The memory cell C12' may include a gate electrode extending in the X-axis direction. The gate electrode may form NFETs, that is, the first to fourth NFETs N21 to N24 of FIG. 5, in the NFET region, and may form PFETs, that is, the first PFET P21 and the second PFET P22 of FIG. 5, in the PFET region. Source/drains may be formed at both sides of the gate electrode, and a source/drain may be connected to the pattern of the M1 layer via a contact and a via. The gate electrode may be connected to the pattern of the M1 layer via a contact and a via.

The memory cell C21' may include an NFET region and a PFET region, extending in the Y-axis direction. For example, as shown in FIG. 6A, NFET regions may extend, in the Y-axis direction, between PFET regions of the memory cell C21', extending in the Y-axis direction. The memory cell C21' may include a gate electrode extending in the X-axis direction. The gate electrode may form NFETs, that is, the first to fourth NFETs N31 to N34 of FIG. 5, in the NFET region, and may form PFETs, that is, the first PFET P31and the second PFET P32 of FIG. 5, in the PFET region. Source/drains may be formed at both sides of the gate electrode, and a source/drain may be connected to the pattern of the M1 layer via a contact and a via. The gate electrode may be connected to the pattern of the M1 layer via a contact and a via.

The memory cell C22' may include an NFET region and a PFET region, extending in the Y-axis direction. For example, as shown in FIG. 6A, NFET regions may extend, in the Y-axis direction, between PFET regions of the memory cell C22', extending in the Y-axis direction. The memory cell C22' may include a gate electrode extending in the X-axis direction. The gate electrode may form NFETs, that is, the first to fourth NFETs N41 to N44 of FIG. 5, in the NFET region, and may form PFETs, that is, the first PFET P41 and the second PFET P42 of FIG. 5, in the PFET region. Source/drains may be formed at both sides of the gate electrode, and a source/drain may be connected to the pattern of the M1 layer via a contact and a via. The gate electrode may be connected to the pattern of the M1 layer via a contact and a via.

In some embodiments, the memory cells included in the layout 60 may have mutually flipped layouts. For example, the layout of the memory cell C1 1' may be symmetrical to the layout of the memory cell C12' with respect to a boundary between the memory cell C11' and the memory cell C12'. For example, the layout of the memory cell C11' may correspond to a layout in which the layout of the memory cell C12' is flipped with respect to an axis parallel to a Y axis. In addition, the layout of the memory cell C1 1' may be symmetrical to the layout of the memory cell C21' with respect to a boundary between the memory cell C11' and the memory cell C2 1'. For example, the layout of the memory cell C11' may correspond to a layout in which the layout of the memory cell C21' is flipped with respect to an axis parallel to an X axis. In addition, the layout of the memory cell C12' may be symmetrical to the layout of the memory cell C22' with respect to a boundary between the memory cell C12' and the memory cell C22'. For example, the layout of the memory cell C12' may correspond to a layout in which the layout of the memory cell C22' is flipped with respect to the axis parallel to the X axis.

Referring to FIG. 6B, patterns to which the negative supply voltage VSS is applied may extend in the backside wiring layer under the substrate of FIG. 6A. For example, as shown in FIG. 6B, the first pattern BM11, the second pattern BM12, and a third pattern BM13 may extend parallel to each other in the Y-axis direction, and the negative supply voltage VSS may be applied to the first to third patterns BM11, BM12, and BM13. As described above with reference to FIG. 1, through silicon vias may be arranged on the first to third patterns BM11, BM12, and BM13, and the memory cells may receive the negative supply voltage VSS via the through silicon vias.

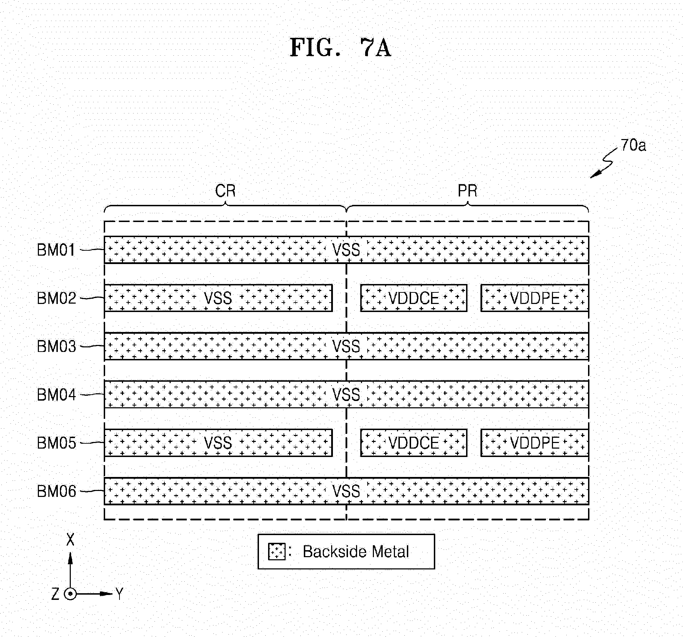

FIGS. 7A to 7E are plan views showing layouts of an integrated circuit according to embodiments. For example, the plan views of FIG. 7A to 7E show patterns of a backside wiring layer, to which a supply voltage is applied, in a cell region CR and a peripheral region PR. As described above with reference to FIG. 3, the cell voltage VDDC as a positive supply voltage may be generated from the external cell voltage VDDCE, and the peripheral voltage VDDP as a positive supply voltage may be generated from the external peripheral voltage VDDPE.

Referring to FIG. 7A, a layout 70a may include the cell region CR and the peripheral region PR, adj acent to each other in the Y-axis direction. The layout 70a may include patterns of a backside wiring layer extending in the Y-axis direction in the cell region CR and/or the peripheral region PR. In some embodiments, the patterns of the backside wiring layer, to which the negative supply voltage VSS is applied, may continuously extend in the cell region CR and the peripheral region PR. For example, as shown in FIG. 7A, a first pattern BM01, a third pattern BM03, a fourth pattern BM04, and a sixth pattern BM06, to which the negative supply voltage VSS is applied, may extend parallel to each other in the Y-axis direction in the cell region CR and the peripheral region PR. As shown in FIG. 7A, a second pattern BM02 and a fifth pattern BM05, to which the negative supply voltage VSS is applied in the cell region CR, may extend parallel to each other in the Y-axis direction in the cell region CR. In addition, the patterns of the backside wiring layer, to which the external cell voltage VDDCE or the external peripheral voltage VDDPE is applied in the peripheral region PR, may extend in the Y-axis direction.

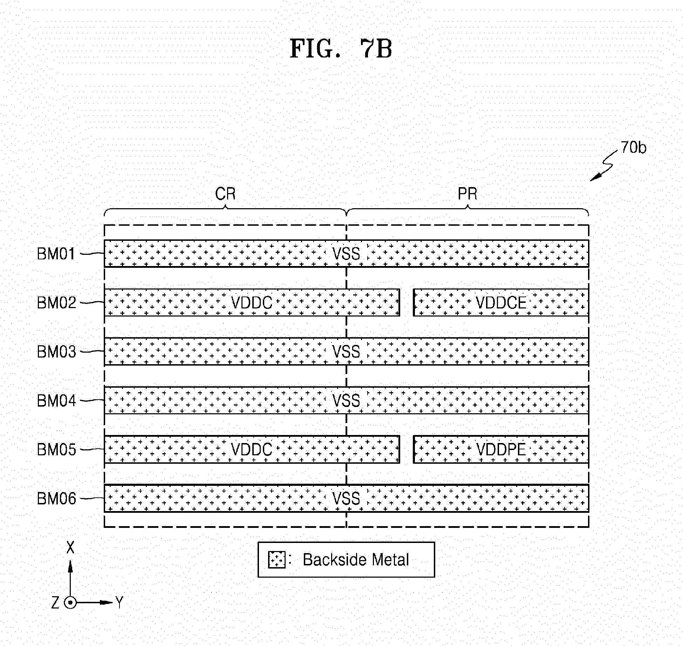

Referring to FIG. 7B, a layout 70b may include the cell region CR and the peripheral region PR, adj acent to each other in the Y-axis direction. The layout 70b may include patterns of a backside wiring layer extending in the Y-axis direction in the cell region CR and/or the peripheral region PR. In some embodiments, patterns of the backside wiring layer, to which the cell voltage VDDC is applied, may continuously extend in the cell region CR and the peripheral region PR. For example, as shown in FIG. 7B, the second pattern BM02 and the fifth pattern BM05, to which the cell voltage VDDC is applied, may extend parallel to each other in the Y-axis direction in the cell region CR and the peripheral region PR. As shown in FIG. 7B, the first pattern BM01, the third pattern BM03, the fourth pattern BM04, and the sixth pattern BM06, to which the negative supply voltage VSS is applied, may extend parallel to each other in the Y-axis direction in the cell region CR and the peripheral region PR. In addition, patterns of the backside wiring layer, to which the external cell voltage VDDCE or the external peripheral voltage VDDPE is applied in the peripheral region PR, may extend in the Y-axis direction.

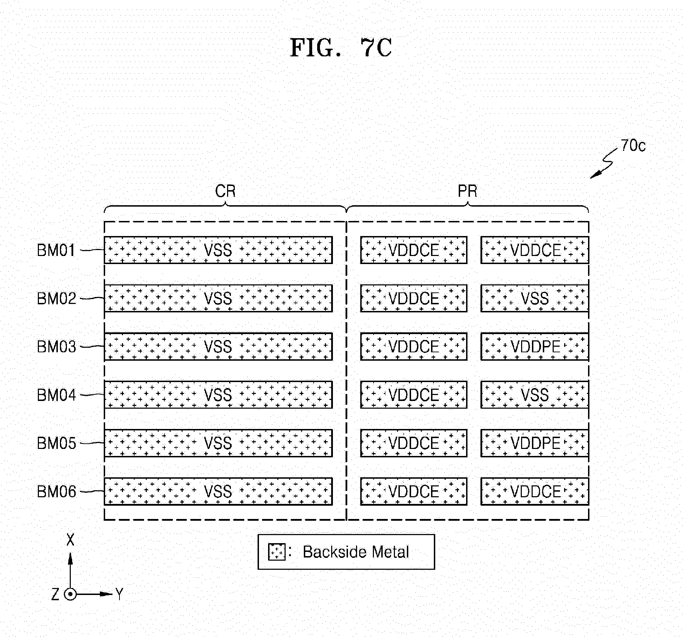

Referring to FIG. 7C, a layout 70c may include the cell region CR and the peripheral region PR, adj acent to each other in the Y-axis direction. The layout 70c may include patterns of a backside wiring layer extending in the Y-axis direction in the cell region CR and/or the peripheral region PR. In some embodiments, patterns of the backside wiring layer, to which the negative supply voltage VSS is applied, may extend in the cell region CR. For example, as shown in FIG. 7C, the first to sixth patterns BM01 to BM06 to which the negative supply voltage VSS is applied may extend parallel to each other in the Y-axis direction in the cell region CR. As shown in FIG. 7C, patterns of the backside wiring layer, to which the external cell voltage VDDCE, the external peripheral voltage VDDPE, or the negative supply voltage VSS is applied in the peripheral region PR, may extend in the Y-axis direction.

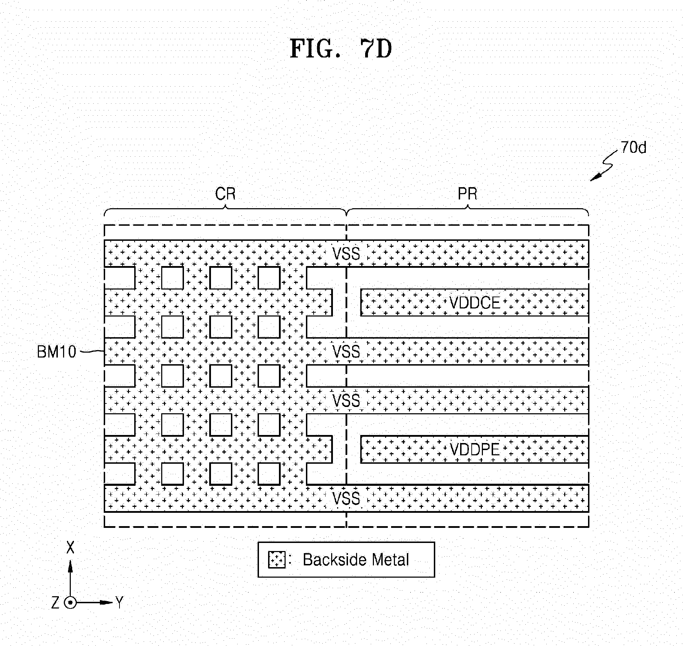

Referring to FIG. 7D, a layout 70d may include the cell region CR and the peripheral region PR, adj acent to each other in the Y-axis direction. The layout 70d may include patterns of a backside wiring layer extending in the Y-axis direction in the cell region CR and/or the peripheral region PR. In some embodiments, patterns of the backside wiring layer, to which the negative supply voltage VSS is applied, may continuously extend in the Y-axis direction in the cell region CR and the peripheral region PR, and may extend in the X-axis direction in the cell region CR. For example, as shown in FIG. 7D, a pattern BM10 may include a portion continuously extending in the Y-axis direction in the cell region CR and the peripheral region PR. The pattern BM10 may include a portion extending in the Y-axis direction in the cell region CR, and may include a portion extending in the X-axis direction. Accordingly, as shown in FIG. 7D, the pattern BM10 may have a mesh shape in the cell region CR. As shown in FIG. 7D, patterns of the backside wiring layer, to which the external cell voltage VDDCE or the external peripheral voltage VDDPE is applied in the peripheral region PR, may extend in the Y-axis direction.

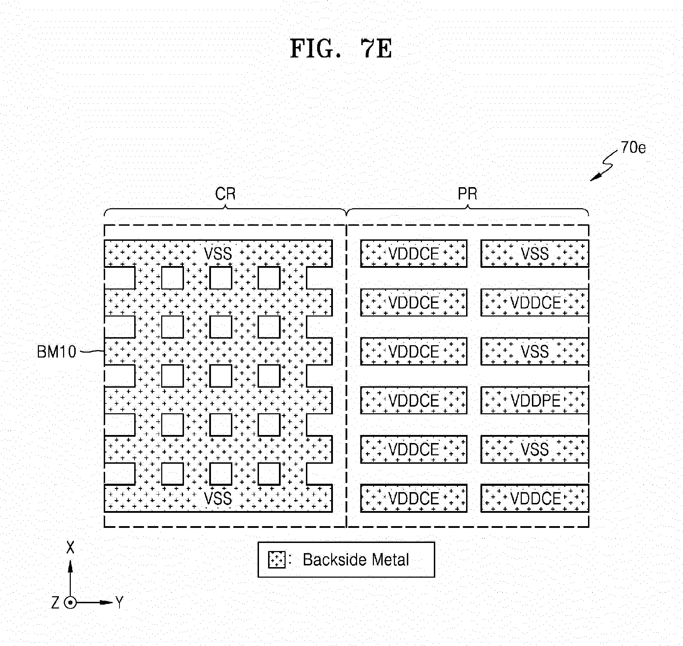

Referring to FIG. 7E, a layout 70e may include the cell region CR and the peripheral region PR, adj acent to each other in the Y-axis direction. The layout 70e may include patterns of a backside wiring layer extending in the Y-axis direction in the cell region CR and/or the peripheral region PR. In some embodiments, patterns of the backside wiring layer, to which the negative supply voltage VSS is applied, may extend in the Y-axis direction and the X-axis direction in the cell region CR. For example, as shown in FIG. 7E, the pattern BM10 may include a portion extending in the Y-axis direction in the cell region CR, and may include a portion continuously extending in the X-axis direction in the cell region CR. Accordingly, as shown in FIG. 7E, the pattern BM10 may have a mesh shape in the cell region CR. As shown in FIG. 7E, patterns of the backside wiring layer, to which the external cell voltage VDDCE, the external peripheral voltage VDDPE, or the negative supply voltage VSS is applied in the peripheral region PR, may extend in the Y-axis direction.

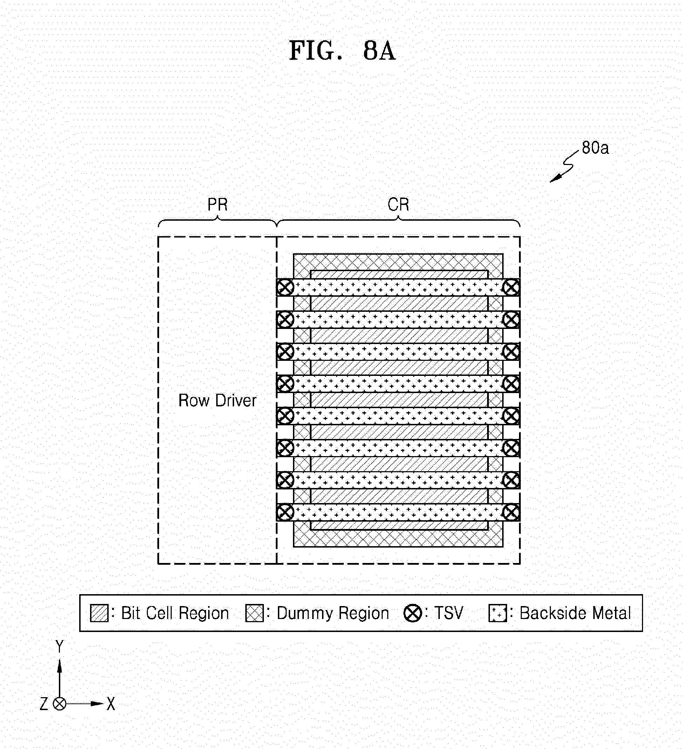

FIGS. 8A to 8E are plan views showing layouts of an integrated circuit according to embodiments. For example, the plan views of FIGS. 8A to 8E show patterns of a backside wiring layer and through silicon vias in the cell region CR and the peripheral region PR. The through silicon vias in FIGS. 8A to 8E are shown for understanding despite the patterns of the backside wiring layer.

The cell region CR may include a bit cell region and a dummy region. The bit cell region may include memory cells, as described above with reference to FIGS. 6A and 6B. The dummy region may be located outside the bit cell region, and may include dummy cells and/or tap cells. A tap cell may bias a substrate or a well, and a dummy cell may be adjacent to a tap cell. In some embodiments, a dummy cell and a tap cell may have the same size as a memory cell. For example, the dummy cell and the tap cell may have the same area as the memory cell, and may have the same horizontal length and the same vertical length. Herein, cells arranged in the dummy region, that is, dummy cells and tap cells, may be collectively referred to as dummy cells.

The peripheral region PR may include a row driver, and as described above with reference to FIG. 3, the row driver may be connected to a plurality of word lines extending in the cell region CR. A control signal commonly provided to cells arranged in the same row in the cell region CR may be applied to a pattern of a backside wiring layer. For example, patterns of a backside wiring layer may correspond to the plurality of word lines WLs. As described above with reference to FIG. 1, the pattern of the backside wiring layer may be connected to the pattern of the first wiring layer M1 via the through silicon via, and accordingly, the pattern of the backside wiring layer may extend in parallel with a pattern corresponding to a word line extending in the first wiring layer M1 or a second wiring layer higher than the first wiring layer M1, and accordingly, parasitic resistance of the word line may decrease.

Referring to FIG. 8A, a layout 80a may include the cell region CR and the peripheral region PR, adjacent to each other in the X-axis direction. Patterns of a backside wiring layer, corresponding to a plurality of word lines, may extend in the X-axis direction in the cell region CR. In some embodiments, a plurality of through silicon vias may be connected to the patterns of the backside wiring layer outside the dummy region. For example, as shown in FIG. 8A, the patterns of the backside wiring layer may extend in the X-axis direction through the bit cell region and the dummy region, and the through silicon vias may be connected to the patterns of the backside wiring layer outside the dummy region. The through silicon vias may be connected to the patterns of the first wiring layer M1, and the row driver may be connected to the patterns of the first wiring layer M1.

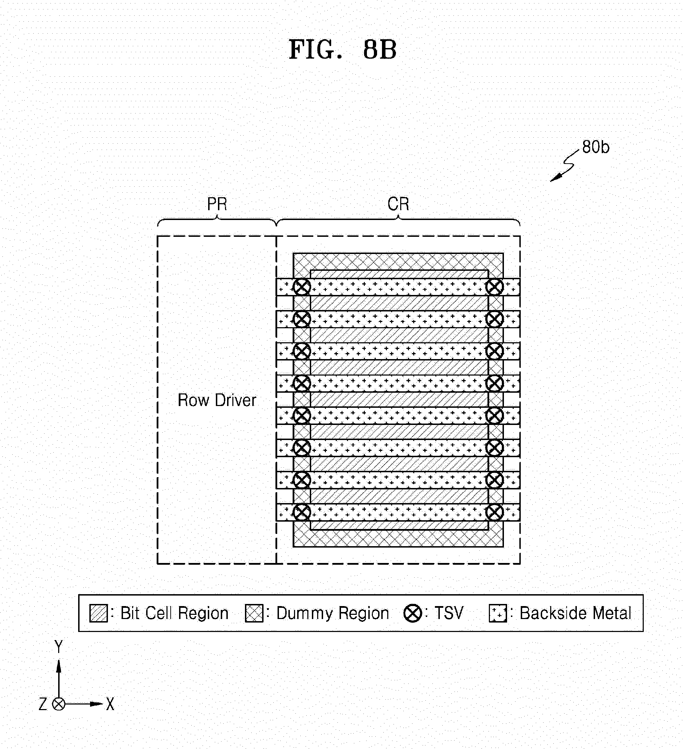

Referring to FIG. 8B, a layout 80b may include the cell region CR and the peripheral region PR, adjacent to each other in the X-axis direction. Patterns of a backside wiring layer, corresponding to a plurality of word lines, may extend in the X-axis direction in the cell region CR. In some embodiments, a plurality of through silicon vias may be connected to the patterns of the backside wiring layer in the dummy region. For example, as shown in FIG. 8B, the patterns of the backside wiring layer may extend in the X-axis direction through the bit cell region and the dummy region, and the through silicon vias may be connected to the patterns of the backside wiring layer in the dummy region. The through silicon vias may pass through a dummy cell and/or tap cell of the dummy region in the vertical direction, and may be connected to the patterns of the first wiring layer M1. The row driver may be connected to the patterns of the first wiring layer M1.

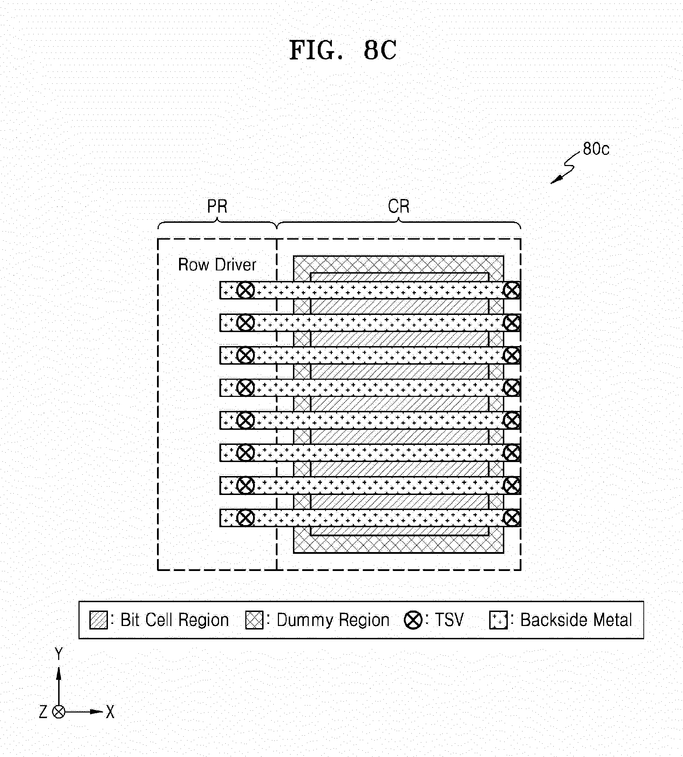

Referring to FIG. 8C, a layout 80c may include the cell region CR and the peripheral region PR, adjacent to each other in the X-axis direction. Patterns of a backside wiring layer, corresponding to a plurality of word lines, may continuously extend in the X-axis direction in the peripheral region PR and the cell region CR. In some embodiments, a plurality of through silicon vias may be connected to the patterns of the backside wiring layer in the peripheral region PR, and may be connected to the patterns of the backside wiring layer outside the dummy region. For example, as shown in FIG. 8C, the through silicon vias may be connected to the patterns of the backside wiring layer in the peripheral region PR, and the row driver may be connected to the patterns of the backside wiring layer via the through silicon vias. In addition, the through silicon vias may be connected to the patterns of the backside wiring layer outside the dummy region of the cell region CR.

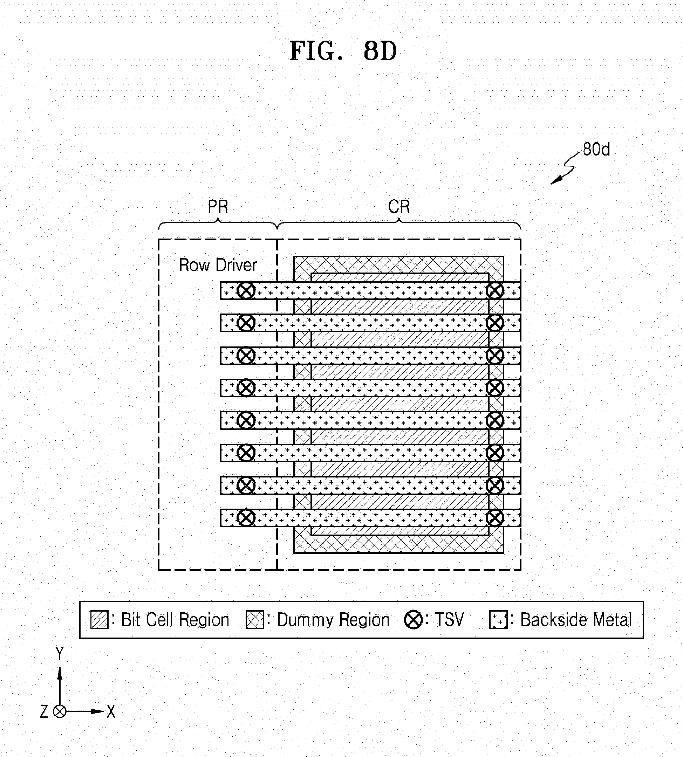

Referring to FIG. 8D, a layout 80d may include the cell region CR and the peripheral region PR, adjacent to each other in the X-axis direction. Patterns of a backside wiring layer, corresponding to a plurality of word lines, may continuously extend in the X-axis direction in the peripheral region PR and the cell region CR. In some embodiments, a plurality of through silicon vias may be connected to the patterns of the backside wiring layer in the peripheral region PR, and may be connected to the patterns of the backside wiring layer in the dummy region. For example, as shown in FIG. 8D, the through silicon vias may be connected to the patterns of the backside wiring layer in the peripheral region PR, and the row driver may be connected to the patterns of the backside wiring layer via the through silicon vias. In addition, the through silicon vias may be connected to the patterns of the backside wiring layer in the dummy region of the cell region CR.

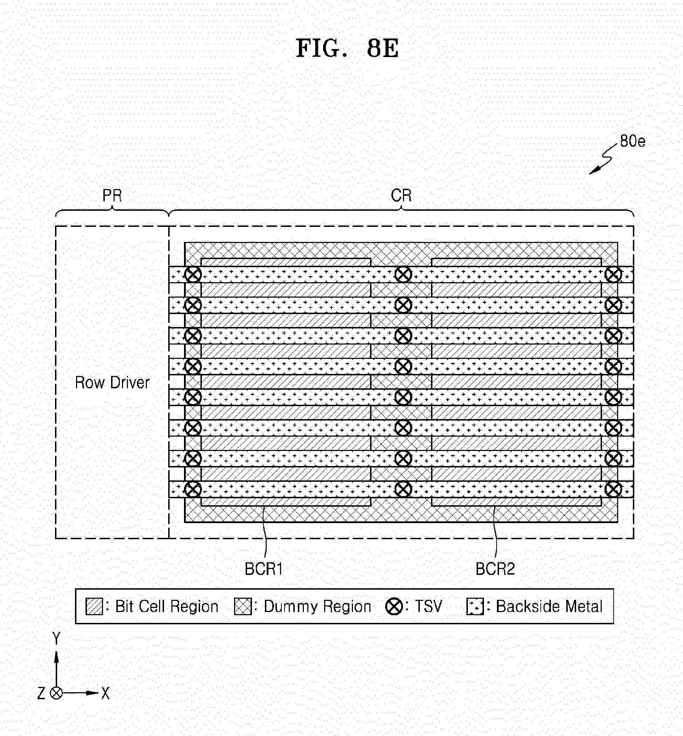

Referring to FIG. 8E, a layout 80e may include the cell region CR and the peripheral region PR, adjacent to each other in the X-axis direction. The cell region CR may include the dummy region, and may include a first bit cell region BCR1 and a second bit cell region BCR2, spaced apart from each other in the X-axis direction. Patterns of a backside wiring layer, corresponding to a plurality of word lines, may extend parallel to each other in the X-axis direction through the dummy region, the first bit cell region BCR1, and the second bit cell region BCR2 in the cell region CR. In some embodiments, a plurality of through silicon vias may be connected to the patterns of the backside wiring layer in the dummy region. For example, as shown in FIG. 8E, the through silicon vias may be connected to the patterns of the backside wiring layer in the dummy region adjacent to an edge of the cell region CR, and may be connected to the patterns of the backside wiring layer in the dummy region between the first bit cell region BCR1 and the second bit cell region BCR2. Accordingly, parasitic resistance of a word line crossing the first bit cell region BCR1 and the second bit cell region BCR2 may decrease.

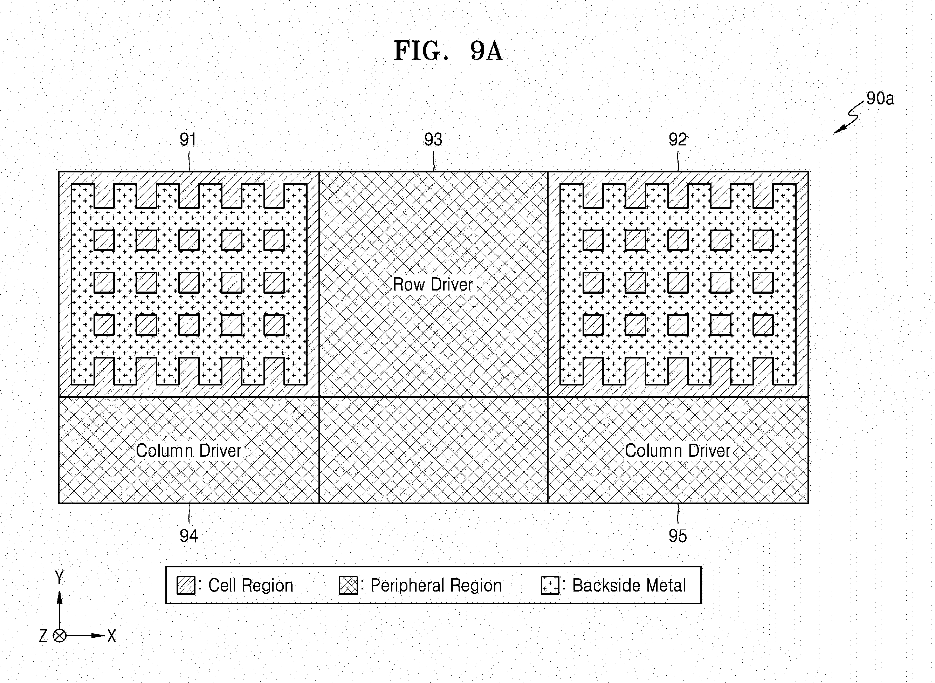

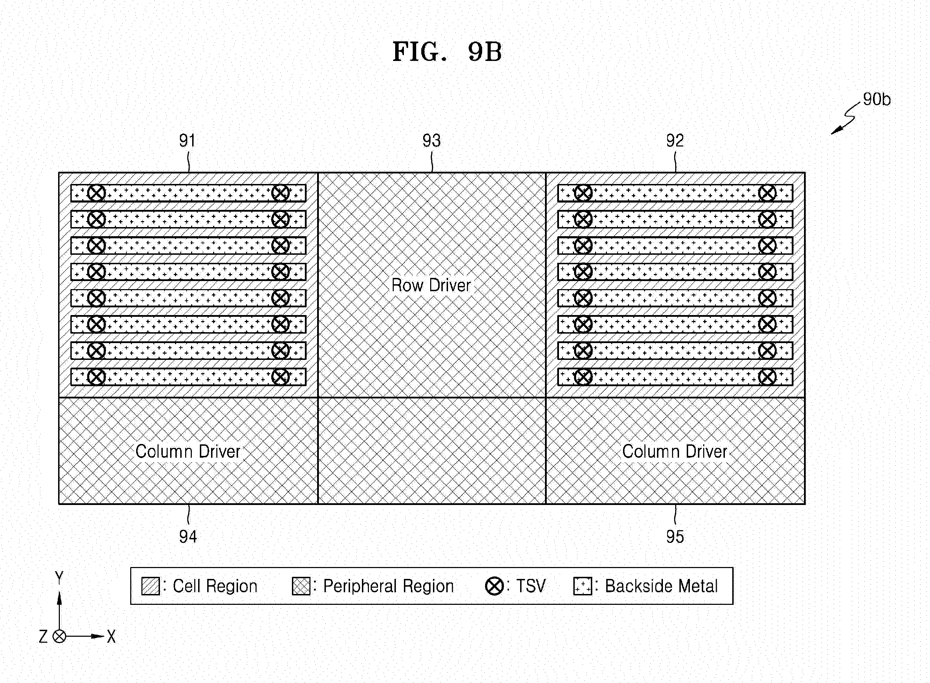

FIGS. 9A and 9B are plan views showing layouts of an integrated circuit according to embodiments. For example, the plan view of FIGS. 9A and 9B show layouts 90a and 90b corresponding to the memory device 30 of FIG. 3. For convenience of illustration, the plan views of FIGS. 9A and 9B illustrate only patterns of a backside wiring layer included in a cell region, but in some embodiments, as described above with reference to FIGS. 7A to 7E and the like, the patterns of the backside wiring layer may extend in a peripheral region.

Referring to FIG. 9A, the layout 90a may include a first cell array 91 and a second cell array 92 in the cell region, and may include a row driver 93, a first column driver 94, and a second column driver 95 in the peripheral region. The layout 90a may include patterns of a backside wiring layer, to which a supply voltage, for example, the negative supply voltage VSS, is applied, under a cell array. For example, as in the example described above with reference to FIG. 7E, the layout 90a may include patterns of the backside wiring layer, extending under the first cell array 91, and patterns of the backside wiring layer, extending under the second cell array 92. In some embodiments, the layout 90a may include patterns of the backside wiring layer, extending in the Y-axis direction under the first cell array 91 and the second cell array 92, as described above with reference to FIGS. 8A to 8D.

Referring to FIG. 9B, the layout 90b may include the first cell array 91 and the second cell array 92 in the cell region, and may include the row driver 93, the first column driver 94, and the second column driver 95 in the peripheral region. The layout 90b may include patterns of a backside wiring layer corresponding to word lines under a cell array. For example, as in the examples described with reference to FIGS. 8A and 8B, the layout 90b may include patterns of the backside wiring layer, extending under the first cell array 91 in the X-axis direction, and through silicon vias connected to the patterns of the backside wiring layer. In addition, the layout 90b may include patterns of the backside wiring layer, extending under the second array cell 92 in the X-axis direction, and through silicon vias connected to the patterns of the backside wiring layer. In some embodiments, as described above with reference to FIGS. 8C and 8D, the layout 90b may include patterns of the backside wiring layer, extending to the row driver 93, and through silicon vias arranged in the row driver 93. In addition, in some embodiments, each of the first cell array 91 and the second cell array 92 may include two or more cell arrays spaced apart from each other, as described above with reference to FIG. 8E, and through silicon vias may be arranged between cell arrays spaced apart from each other.

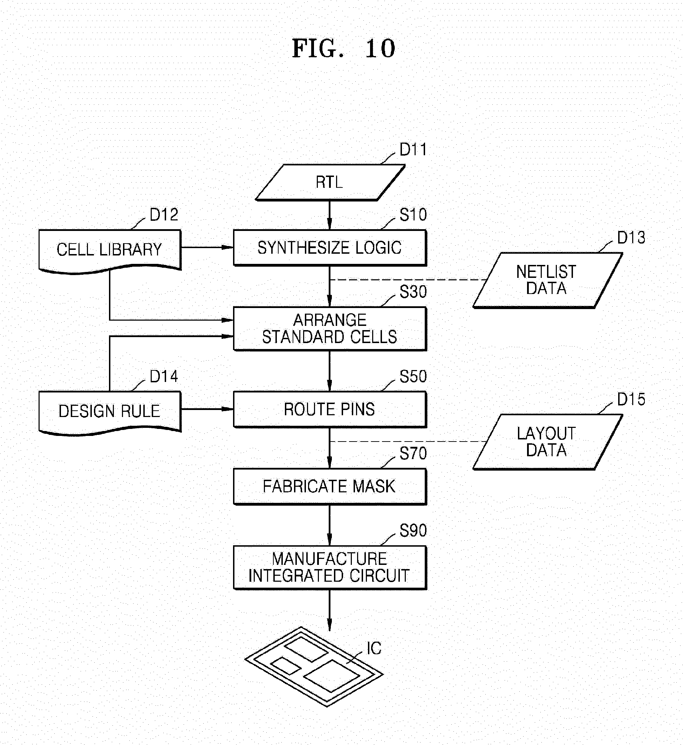

FIG. 10 is a flowchart showing a method of manufacturing an integrated circuit IC, according to an embodiment. In detail, the flowchart of FIG. 10 shows an example of a method of manufacturing the integrated circuit IC including standard cells. A standard cell is a unit of a layout included in an integrated circuit, and may be designed to perform a predefined function. As shown in FIG. 10, the method of manufacturing the integrated circuit IC may include operations S10, S30, S50, S70, and S90.

A cell library (or standard cell library) D12 may include information about standard cells, for example, information about functions, characteristics, layouts, or the like. In some embodiments, the cell library D12 may define a tap cell and a dummy cell as well as functional cells that generate an output signal from an input signal. In some embodiments, the cell library D12 may define memory cells and dummy cells, which have the same size.

A design rule D14 may include requirements that a layout of the integrated circuit IC must comply with. For example, the design rule D14 may include requirements for a space between patterns in the same layer, a minimum width of a pattern, a routing direction of a wiring layer, and the like. In some embodiments, the design rule D14 may define a minimum separation distance within the same track of a wiring layer.

In operation S10, a logic synthesis operation of generating netlist data D13 from RTL data D11 may be performed. For example, a semiconductor design tool (for example, a logic synthesis tool) may perform logic synthesis by referring to the cell library D12 from the RTL data D11 written in a hardware description language (HDL), such as VHSIC hardware description language (VHDL) and Verilog, and may generate the netlist data D13 including a bitstream or a netlist. The netlist data D13 may correspond to an input of place and routing to be described below.

In operation S30, standard cells may be arranged. For example, a semiconductor design tool (for example, a place and route tool) may arrange standard cells used in the netlist data D13 by referring to the cell library D12. In some embodiments, the semiconductor design tool may arrange a standard cell in a row extending in the X-axis direction or the Y-axis direction, and the arranged standard cell may receive power from a power rail extending along boundaries of the row.

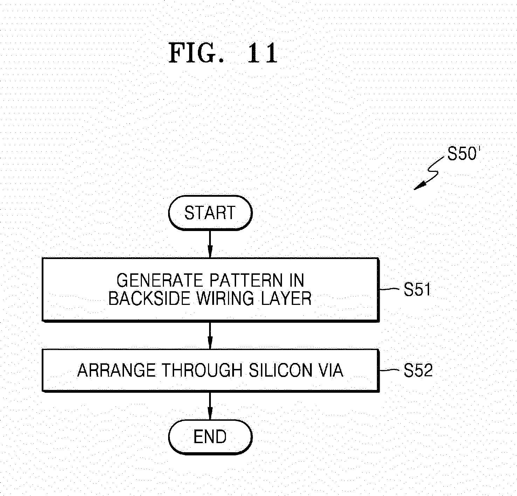

In operation S50, pins of standard cells may be routed. For example, a semiconductor design tool may generate interconnections electrically connecting output pins to input pins of arranged standard cells, and may generate layout data D15 that defines the arranged standard cells and the generated interconnections. An interconnection may include a via of a via layer and/or patterns of wiring layers. The wiring layers may include a backside wiring layer located under a gate electrode as well as a wiring layer located over the gate electrode, such as the first wiring layer M1. The layout data D15 may have a format, such as GDSII, and may include geometric information of cells and interconnections. The semiconductor design tool may refer to the design rule D14 while routing the pins of the cells. The layout data D15 may correspond to an output of place and routing. An example of operation S50 is described below with reference to FIG. 11. Operation S50 may alone be or operation S30 and operation S50 may collectively be referred to as a method of designing an integrated circuit.

In operation S70, an operation of fabricating a mask may be performed. For example, optical proximity correction (OPC) for correcting a distortion phenomenon, such as refraction, caused by characteristics of light in photolithography may be applied to the layout data D15. Patterns on a mask may be defined to form patterns arranged in a plurality of layers based on OPC-applied data, and at least one mask (or photomask) for forming patterns of each of a plurality of layers may be fabricated. In some embodiments, the layout of the integrated circuit IC may be restrictively modified in operation S70, and the restrictive modification of the integrated circuit IC in operation S70 may be referred to as design polishing as post-processing for optimizing the structure of the integrated circuit IC.

In operation S90, an operation of manufacturing the integrated circuit IC may be performed. For example, the integrated circuit IC may be manufactured by patterning a plurality of layers by using at least one mask fabricated in operation S70. Front-end-of-line (FEOL) may include, for example, planarizing and cleaning a wafer, forming a trench, forming a well, forming a gate electrode, and forming a source and a drain. Individual elements, such as transistors, capacitors, resistors, or the like, may be formed on a substrate by FEOL. In addition, back-end-of-line (BEOL) may include, for example, silicidating a gate and source and drain regions, adding a dielectric, planarizing, forming a hole, adding a metal layer, forming a via, forming a passivation layer, and the like. Individual elements, such as transistors, capacitors, resistors, or the like, may be interconnected by BEOL. In some embodiments, middle-of-line (MOL) may be performed between FEOL and BEOL, and contacts may be formed on individual elements. Afterwards, the integrated circuit IC may be packaged in a semiconductor package and may be used as a component in various applications.

FIG. 11 is a flowchart showing a method of designing an integrated circuit, according to an embodiment. For example, the flowchart of FIG. 11 shows an example of operation S50 of FIG. 10. As described above with reference to FIG. 10, pins may be routed in operation S50' of FIG. 11. As shown in FIG. 11, operation S50' may include operation S51 and operation S52.

Referring to FIG. 11, a pattern may be generated in a backside wiring layer in operation S51. For example, a semiconductor design tool may use a backside wiring layer as a routing source for routing pins. Accordingly, the backside wiring layer may be used to route a power pin for power supply as well as an input pin and an output pin of a standard cell. Due to increased routing resources, routing congestion may be eliminated, interconnection may be simplified, and signal paths may be shortened as a result.

In operation S52, a through silicon via may be arranged. For example, a semiconductor design tool may arrange a through silicon via to connect the pattern of the backside wiring layer generated in operation S51 to a pattern of the first wiring layer M1. In some embodiments, as described above with reference to FIGS. 8A to 8E, the through silicon via may be arranged outside a bit cell array. In some embodiments, the through silicon via may pass through a dummy cell in the vertical direction.

FIG. 12 is a block diagram showing a system-on-chip (SoC) 120 according to an embodiment. The SoC 120 may be referred to as an integrated circuit in which components of a computing system or other electronic systems are integrated. For example, an application processor (AP) as an example of the SoC 120 may include a processor and components for other functions. As shown in FIG. 12, the SoC 120 may include a core 121, a digital signal processor (DSP) 122, a graphics processing unit (GPU) 123, an embedded memory 124, a communication interface 125, and a memory interface 126. Components of the SoC 120 may communicate with each other through a bus 127.

The core 121 may process instructions and control operations of the components included in the SoC 120. For example, the core 121 may drive an operating system and execute applications on the operating system by processing a series of instructions. The DSP 122 may generate useful data by processing a digital signal, for example, a digital signal provided from the communication interface 125. The GPU 123 may generate, from image data provided from the embedded memory 124 or the memory interface 146, data for an image output via a display device, and may encode the image data. In some embodiments, the memory device described with reference to the drawings may be included in the core 121, the DSP 122, and/or the GPU 123 as a cache memory and/or a buffer. Accordingly, due to the high reliability and efficiency of the memory device, the core 121, the DSP 122, and/or the GPU 123 may also have high reliability and efficiency.

The embedded memory 124 may store data required for the core 121, the DSP 122, and the GPU 123 to operate. In some embodiments, the embedded memory 124 may include the memory device described with reference to the drawings. Accordingly, the embedded memory 124 may have a reduced area and high efficiency, and as a result, the operational reliability and efficiency of the SoC 120 may be improved.

The communication interface 125 may provide an interface for a communication network or one-to-one communication. The memory interface 126 may provide an interface with respect to an external memory of the SoC 120, for example, DRAM, flash memory, or the like.

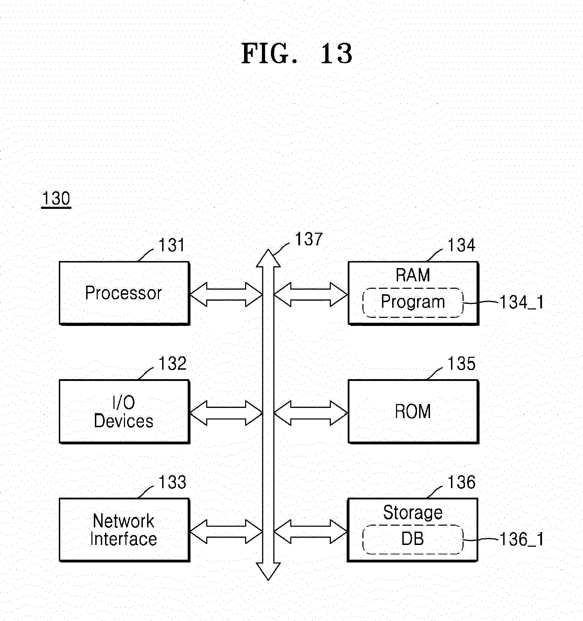

FIG. 13 is a block diagram showing a computing system 130 including a memory storing a program, according to an embodiment. According to embodiments, a method of designing an integrated circuit, for example, at least some of operations in the flowchart described above, may be performed by the computing system 130 (or computer).

The computing system 130 may be a stationary computing system, such as a desktop computer, a workstation, or a server, or may be a portable computing system, such as a laptop computer. As shown in FIG. 13, the computing system 130 may include a processor 131, input/output devices 132, a network interface 133, random access memory (RAM) 134, read only memory (ROM) 135, and a storage 136. The processor 131, the input/output devices 132, the network interface 133, the RAM 134, the ROM 135, and the storage 136 may be connected to a bus 137, and may communicate with each other via the bus 137.

The processor 131 may be referred to as a processing unit, and for example, like a microprocessor, an AP, a DSP, and a GPU, the processor 110, may include at least one core capable of executing any instruction set (for example, Intel Architecture-32 (IA-32), 64-bit extension IA-32, x86-64, PowerPC, Sparc, MIPS, ARM, or IA-64). For example, the processor 131 may access a memory, that is, the RAM 134 or the ROM 135, via the bus 137, and may execute instructions stored in the RAM 134 or the ROM 135.

The RAM 134 may store a program 134_1 for a method of designing an integrated circuit according to an embodiment or at least a portion thereof, and the program 134_1 may allow the processor 131 to perform a method of designing an integrated circuit, for example, at least some of operations of FIG. 10. For example, the program 134_1 may include a plurality of instructions executable by the processor 131, and the plurality of instructions included in the program 134_1 may allow the processor 131 to perform, for example, at least some of operations included in the flowcharts described above.

The storage 136 may not lose stored data even when power supplied to the computing system 130 is cut off. For example, the storage 136 may include a non-volatile memory device, or may include a storage medium, such as magnetic tape, an optical disk, or a magnetic disk. In addition, the storage 136 may be detachable from the computing system 130. The storage 136 may store the program 134_1 according to an embodiment, and before the program 134_1 is executed by the processor 131, the program 134_1 or at least a portion thereof may be loaded into the RAM 134 from the storage 136. Alternatively, the storage 136 may store a file written in a program language, and the program 134_1 generated by a compiler or the like from the file or at least a portion thereof may be loaded into the RAM 134. In addition, as shown in FIG. 13, the storage 136 may store a database 136_1, and the database 136_1 may include information necessary for designing an integrated circuit, for example, information about designed blocks, the cell library D12 and/or the design rule D14 of FIG. 10.

The storage 136 may also store data to be processed by the processor 131 or data processed by the processor 131. For example, the processor 131 may generate data by processing data stored in the storage 136 according to the program 134_1 and may store the generated data in the storage 136. For example, the storage 136 may store the RTL data D11, the netlist data D13, and/or the layout data D15 of FIG. 10.

The input/output devices 132 may include input devices, such as keyboards or pointing devices, and may include output devices, such as display devices or printers. For example, a user may trigger execution of the program 134_1 by the processor 131 via the input/output devices 132, may input the RTL data D11 and/or the netlist data D13 of FIG. 10, or may check the layout data D15 of FIG. 10.

The network interface 133 may provide access to a network outside the computing system 130. For example, a network may include a plurality of computing systems and communication links, and the communication links may include wired links, optical links, wireless links, or any other type of links.

While embodiments have been particularly shown and described with reference to embodiments of the present disclosure, it will be understood that various changes in form and details may be made therein without departing from the spirit and scope of the following claims and their equivalents.

## Claims

1. An integrated circuit comprising:
a cell region in which a plurality of cells are arranged; and
a peripheral region in which a circuit configured to control the plurality of cells is arranged,
wherein the cell region comprises:
a plurality of first gate lines over a substrate;
a plurality of first patterns in a first wiring layer above the plurality of first gate lines;
a plurality of second patterns extending in a first horizontal direction in a backside wiring layer under the substrate; and
a plurality of first vias, each of the plurality of first vias passing through the substrate in a vertical direction,
wherein each of the plurality of first vias comprises a top surface connected to a respective one of the plurality of first patterns and a bottom surface connected to a respective one of the plurality of second patterns.

2. The integrated circuit of claim 1, wherein the plurality of second patterns comprise at least one second pattern configured to receive a first supply voltage provided to the plurality of cells.

3. The integrated circuit of claim 2, wherein the at least one second pattern extends to the peripheral region in the first horizontal direction.

4. The integrated circuit of claim 2, wherein the cell region further comprises a plurality of third patterns extending in the backside wiring layer in a second horizontal direction perpendicular to the first horizontal direction, and
wherein the plurality of third patterns are connected to the plurality of second patterns.

5. The integrated circuit of claim 2, wherein the plurality of second patterns further comprise at least one second pattern configured to receive a second supply voltage provided to the plurality of cells, the at least one second pattern extending to the peripheral region.

6. The integrated circuit of claim 5, wherein the peripheral region further comprises a peripheral circuit configured to generate the second supply voltage from an external supply voltage provided from outside the peripheral region.

7. The integrated circuit of claim 1, wherein the peripheral region comprises:
a plurality of second gate lines over the substrate;
a plurality of fourth patterns extending in the first wiring layer above the plurality of second gate lines;
a plurality of fifth patterns extending in the first horizontal direction in the backside wiring layer; and
a plurality of second vias passing through the substrate in the vertical direction,
wherein each of the plurality of second vias is connected to a respective one of the plurality of fourth patterns and a respective one of the plurality of fifth patterns.

8. The integrated circuit of claim 7, wherein the plurality of fifth patterns comprise at least one fifth pattern configured to receive an external supply voltage provided from outside the peripheral region.

9. The integrated circuit of claim 1, wherein each of the plurality of second patterns is configured to receive a control signal provided commonly to cells, among the plurality of cells, in a row extending in the first horizontal direction.

10. The integrated circuit of claim 9, wherein the plurality of second patterns extend in the peripheral region, and
wherein the peripheral region comprises a plurality of third vias passing through the substrate in the vertical direction and connected to the plurality of second patterns.

11. An integrated circuit comprising:
a cell region in which a plurality of cells are arranged; and
a peripheral region in which a circuit configured to control the plurality of cells is arranged,
wherein the cell region comprises:
a plurality of first gate lines over a substrate;
a plurality of first patterns extending in a first wiring layer above the plurality of first gate lines; and
a plurality of second patterns extending in a first horizontal direction in a backside wiring layer under the substrate,
wherein each of the plurality of second patterns is configured to receive a control signal provided commonly to cells, among the plurality of cells, in a row extending in the first horizontal direction.

12. The integrated circuit of claim 11, wherein the cell region further comprises a plurality of vias, each of the plurality of vias passing through the substrate in a vertical direction and connected to a respective one of the plurality of second patterns.

13. The integrated circuit of claim 12, wherein each of the plurality of vias pass through the substrate in the vertical direction in a region of the cell region between the plurality of cells.

14. The integrated circuit of claim 13, wherein the cell region comprises:
at least one bit cell region in which bit cells included in the plurality of cells are arranged; and
a dummy region in which dummy cells included in the plurality of cells are arranged,
wherein the dummy region comprises the plurality of vias.

15. The integrated circuit of claim 14, wherein the at least one bit cell region comprises a first bit cell region and a second bit cell region,
wherein the plurality of second patterns pass through the first bit cell region and the second bit cell region in the first horizontal direction, and
wherein the plurality of vias are between the first bit cell region and the second bit cell region.
